# EUROPEAN PATENT SPECIFICATION

(11) **EP 0 215 397 B1**
(45) Date of publication and mention of the grant of the patent: **04.01.1995**
(21) Application number: 86112301.6
(22) Date of filing: 05.09.1986
(51) Int. Cl.: H05K 3/00

(54) **Film peeling apparatus**
Vorrichtung zum Abschälen eines Films
Appareil pour peler une pellicule

(30) Priority: 05.09.1985 JP 196694/85; 13.12.1985 JP 280796/85; 17.12.1985 JP 285270/85
(43) Date of publication of application: 25.03.1987
(73) Proprietor: SOMAR CORPORATION, Tokyo 104 (JP)
(72) Inventor: Hamamura, Fumio, Yokohama-shi Kanagawa (JP); Sumi, Shigeo, Hasuda-shi Saitama (JP)
(74) Representative: Boeters, Hans Dietrich, Dr.

(56) References cited:
- EP-A- 0 087 551
- EP-A- 0 217 150
- DE-A- 2 751 862
- DE-A- 3 339 723
- FR-A- 2 360 499
- JP-A-58 091 782
- US-A- 3 951 727
- PATENT ABSTRACTS OF JAPAN, vol. 9, no. 198 (M-404)[1921], 15th August 1985; &JP-A-60 61 458
- PATENT ABSTRACTS OF JAPAN, vol. 9, no. 6 (P-326)[1729], 11th January 1985; & JP-A-59 154 447

## Description

### BACKGROUND OF THE INVENTION

This invention relates to an apparatus for peeling off films and more particularly to an apparatus effective in peeling off protective films stuck onto a board and used to protect the faces thereof.

Printed circuit boards for use in electronic equipment such as computers are provided with a predetermined copper wiring pattern formed on one or both sides of an insulating substrate.

A printed circuit board of that sort is manufactured through a process comprising the steps of laminating a photosentitive resin layer (photoresist) and a translucent resin film (protective film) for protecting the photosentitive resin layer on a conductive layer laid on an insulating substrate through thermocompression bonding; superposing a film having a wiring pattern; exposing the photosensitive resin layer to light for a fixed period of time through the film having the wiring pattern and the translucent resin film; developing the thus exposed photosentitive resin layer after peeling off the translucent resin film to form an etching mask pattern; removing unnecessary portions of the conductive layer by etching; and further removing the remaining photosensitive resin layer. A printed circuit board having a prodetermined wiring pattern is thus prepared.

In the above steps of manufacturing a printed circuit board, the translucent resin film must be peeled off when the photosensitive resin layer is developed after being exposed to light. That step of peeling off the translucent resin film still relies on manual work, which requires a clever-fingered worker as well as an extremely skilled hand to prevent damage and breakdown attributed to unevenly distributed peel stress because the film is thin.

The problem is that lengthy work is required in the manufacture of a printed circuit board because it takes time to peel off the translucent resin film.

European Patent Application EP-A 0217 150 (state of the art pursuant to Article 54(3) and (4) EPC)) discloses an apparatus for peeling off films stuck onto a board, comprising press members for pressing the end surfaces of the films stuck an the board, fluid spray means for sending jets of fluid to the portions of the films thus pressed, and film peeling guide members for attaching the films peeled off the board by means of the fluid spray means and for setting an obtuse angle including a right angle, at which the films are peeled off.

In the manufacturing steps carried out by this apparatus the efficiency of the manufacturing process among several factors also depends on the fact whether the board on wich the films are stuck can be kept in a predetermined position relative to relevant components of the apparatus.

It is therefore an object of the present invention to improve the efficiency of the process of peeling off a film stuck onto a board.

This object is solved by an apparatus according to claim 1.

### SUMMARY OF THE INVENTION

Of the embodiments disclosed by the present invention, a typical one may be outlined as follows.

The peeling apparatus for peeling off films stuck onto a board according to the present invention comprises press members for pressing the end surfaces of the films stuck onto the board, fluid spray means for sending jets of fluid to the portions to which the force has been applied, and film peeling guide members for setting peel directions by changing the peel angles of the films peeled off the board using the fluid spray means with the board with in the range of an obtuse angle and causing the films thus peeled off to attach thereto, or film discharge means for discharging the films guided with the aid of the film peeling guide means.

A gap is formed under the end of each film by applying force thereto using the press member and a jet of fluid is sent to that end portion to ensure that the film is instantly peeled off. Moreover, by causing each film thus peeled off to attach to the film peeling guide member, the film is supplied with uniform peeling and a stabilized peel position, so that the film is made free from damage or breakdown and peeled off the board at the peel angle. Since the angle of each film peeling guide member is variable, the film can be peeled off at an optimum peel angle. The film discharge means for discharging the film stuck onto the film peeling guide member contributes to automatic film peeling and thus a saving in film peeling time by a large margin.

### BRIEF DESCRIPTION OF THE DRAWINGS

Fig. 1 is a sectional view outlining the construction of an apparatus for peeling off a protective film according to the present invention;
Figs. 2, 3 are enlarged sectional views respectively illustrating a printed circuit board and the press member of Fig. 1;
Fig. 4 is an enlarged elevational view of the press mechanism of Fig. 1;
Fig. 5 is an enlarged perspective view of the press member of Fig. 1;
Fig. 6 is a schematic structural drawing taken on line VI-VI of Fig. 4 in the direction of an arrow;
Fig. 7 is an enlarged sectional view of the principal portion of the fluid spray mechanism and the film discharge mechanism of Fig. 1;
Fig. 7A is a view showing a modification of the film discharge mechanism;
Fig. 8 is a perspective view of the principal portion of the fixed belt conveyor together with the film peeling guide member shown in Fig. 1, 7; and
Figs. 9 to 11 show another embodiment of the invention.

### DETAILED DESCRIPTION OF THE PREFERRED EMBODIMENTS

A description will subsequently be given of an embodiment of the present invention applied to a peeling apparatus for peeling off a protective film stuck onto a printed circuit board.

In the accompanying drawings illustrating the embodiment thereof, like reference characters are given to like component parts having the same functions and the repetition of the description thereof will be omitted.

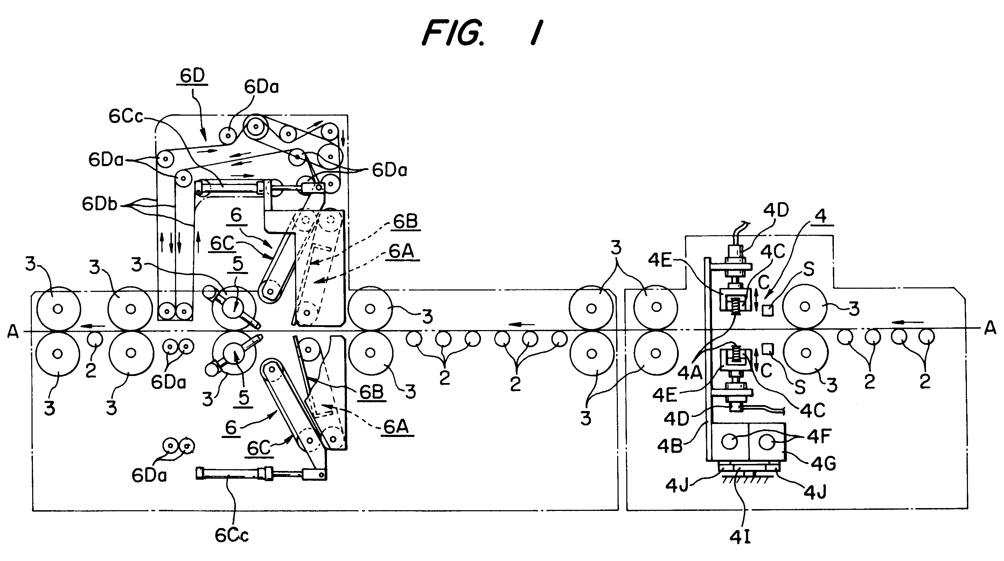

Fig. 1 is a sectional view outlining the construction of a peeling apparatus for peeling off protective films as an embodiment of the present invention.

As shown in Fig. 1, a mechanism for conveying a printed circuit board 1 in the peeling apparatus for peeling off the protective films according to this embodiment comprises conveyor rollers 2 for carrying the printed circuit board 1 and conveyance control rollers 3.

Press mechanisms 4, fluid spray mechanisms 5 and film discharge mechanisms 6 are installed in the conveyance path of the above conveyance mechanism.

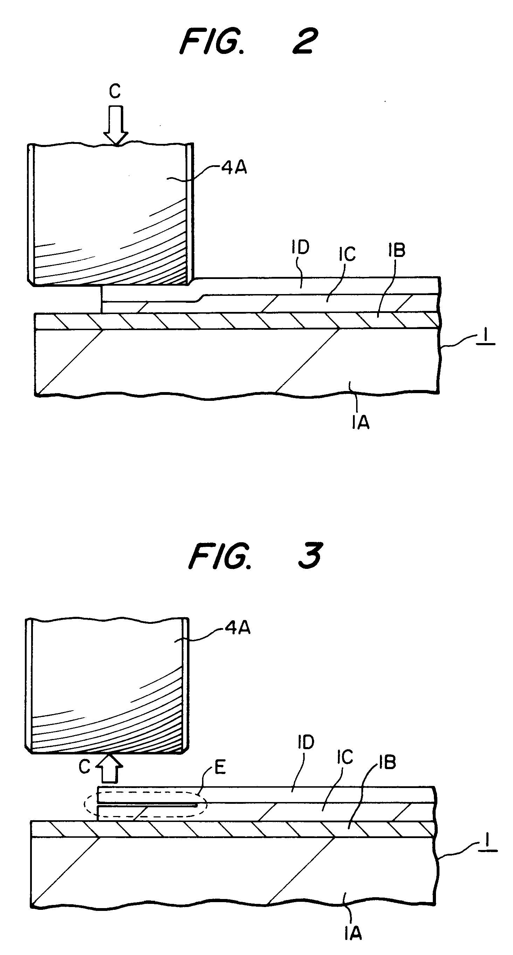

As shown in Fig. 2, 3, the printed circuit board 1 is formed of conductive layers 1B of copper stuck onto both sides (or one side) of an insulating substrate 1A. Laminated bodies, each consisting of a photosensitive resin layer 1C and a translucent (protective) resin film 1D, are stuck onto the conductive layers 1B of the printed circuit board 1 through thermocompression bonding. The photosensitive resin layers 1C are in such a state that they have been exposed to light so as to form a predeterminated pattern.

The conveyor rollers 2 and the conveyance control rollers 3 are so arranged as to carry the printed circuit board 1 in the direction of an arrow in the conveyance path whose view is taken on line A-A of Fig. 1.

Each press mechanism 4 shown in Figs. 1 through 6 is so arranged as to apply force to the end face of the translucent resin film 1D of the printed circuit board 1 with a press member 4A provided with knurls on the circumference of its rotary body. The press member 4A is prepared from, e.g., high-speed steel.

More specifically, when the front end of the printed circuit board 1 is detected by position detectors S shown in Fig. 1, the printed circuit board 1 being conveyed is stopped in between a pair of the upper and lower press members 4A. The position of the printed circuit board 1 is controlled by the position detectors S and the conveyance control rollers 3. Each position detector S is formed of a photosensor. The position of the printed circuit hoard 1 may be controlled by stopper members each controlled by the position detectors S.

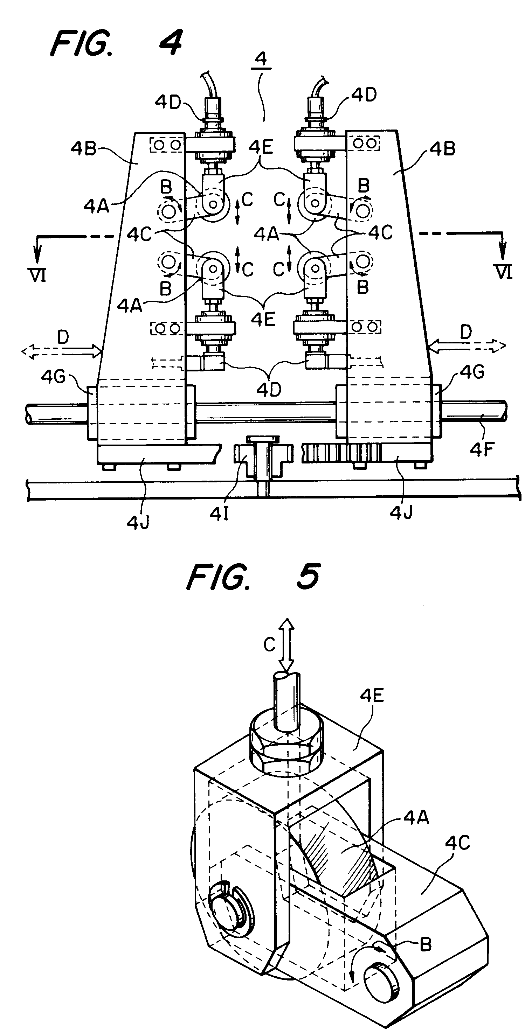

As shown in Fig. 2, the pair of the upper and lower press members 4A are used to apply force to the end surface of the translucent resin film 1D being carried. As shown in Fig. 4, each press member 4A comprises a pair of support members 4B laterally installed in the direction roughly perpendicular to the conveyance direction of the translucent resin film 1D, a pair of arm members 4C rotatable and movable in the direction of an arrow B and a pair of press member support members 4E made movable by air cylinders 4D in the direction of an arrow C. The press member support member 4E and the arm member 4C are so combined as to move linearly in the direction of the arrow C and rotate in the direction of the arrow B. In order to smooth the movement of both members, a proper clearance is provided for the rotary shaft of the arm member 4C.

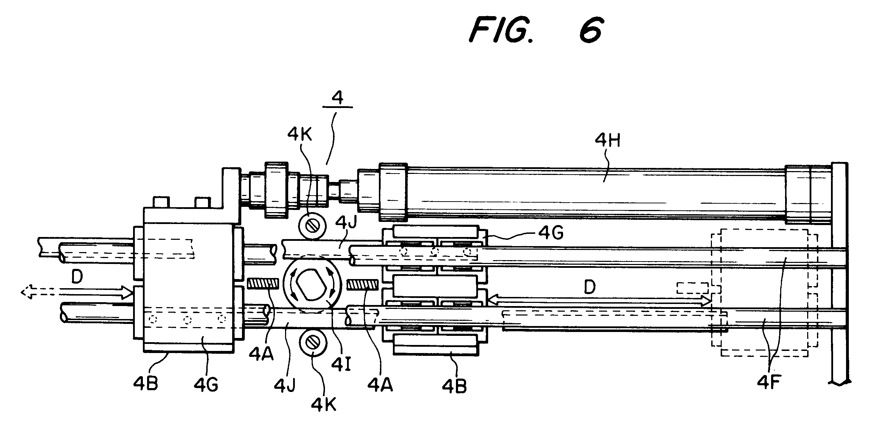

As shown in Figs. 4, 6, the press members 4A are moved or reciprocated in the direction of an arrow D which is roughly prependicular to the conveyance direction of the press members 4A while the front face of the translucent resin film 1D is pressed. In other words, each press member 4A is so arranged as to apply force to the roughly whole area of the front face (end face of the one side of the front portion in the conveyance direction) of the square translucent resin film 1D. The movement of the press member 4A in the direction of the arrow D causes a pair of guide rails 4F to slide, the sliding movement is implemented by an air cylinder 4H installed on one side of the slide member 4G and a rack 4J installed on each slide member 4G coupled to a pinion 4I. The above pinion 4I and the rack 4J are so arranged as to slide the other slide member 4G (on the left of Fig. 6) in the direction opposite to one slide member 4G (on the right of Fig. 6) slid by the air cylinder 4H. The engagement of the pinion 4I and the rack 4J are kept stably by a guide roller 4K.

As shown in Fig. 3, the air cylinder 4D releases the press member 4A with a resilient member (not shown).

The air cylinders 4D, 4H may be replaced with hydraulic or other liquid cylinders, whereas the pinion 4I and the rack 4J may be replaced with other belt mechanisms.

The gap can thus be formed between the photosensitive resin layer 1C and the translucent resin film 1D as shown in Fig. 3 by applying force to the end face of the translucent resin film 1D of the printed circuit board 1 with the press member 4A. The reason for the formation of the gap is that the material for the photosensitive resin layer 1C is different from that for the translucent resin film 1D and, if the former is readily subjected to plastic deformation as compared with the latter, the adhesion there between is nullified by the shearing force applied thereto.

Moreover, the press member 4A installed in the conveyance path of the printed circuit board 1 allows the formation of the gap automatically between the photosensitive resin layer 1C and the translucent resin film 1D.

Although the gap formed between the photosensitive resin layer 1C and the translucent resin film 1D is squeezed by the conveyor rollers 2 or conveyance control rollers 3 while the printed circuit board 1 is carried out by the fluid spray mechanism 5, the photosensitive resin layer 1C and the translucent resin fil 1D will not be bound together again because they have not been treated with thermocompression bonding.

Although the press member 4A is made to slide on the almost whole area along one side while the end face of the translucent resin film 1D is being pressed, it may be made to slide on only the narrow part thereof. However, the press member 4A must be made to slide on the place in which the fluid is sprayed by the fluid spray mechanism 5. translucent resin film 1D is being pressed, it may be made to slide on only the narrow part thereof. However, the press member 4A must be made to slide on the place in which the fluid is sprayed by the fluid spray mechanism 5.

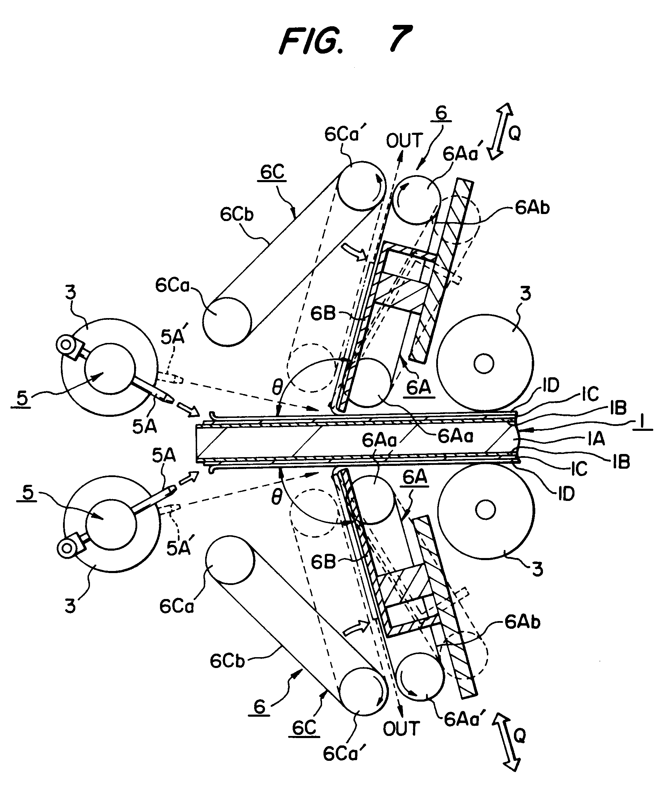

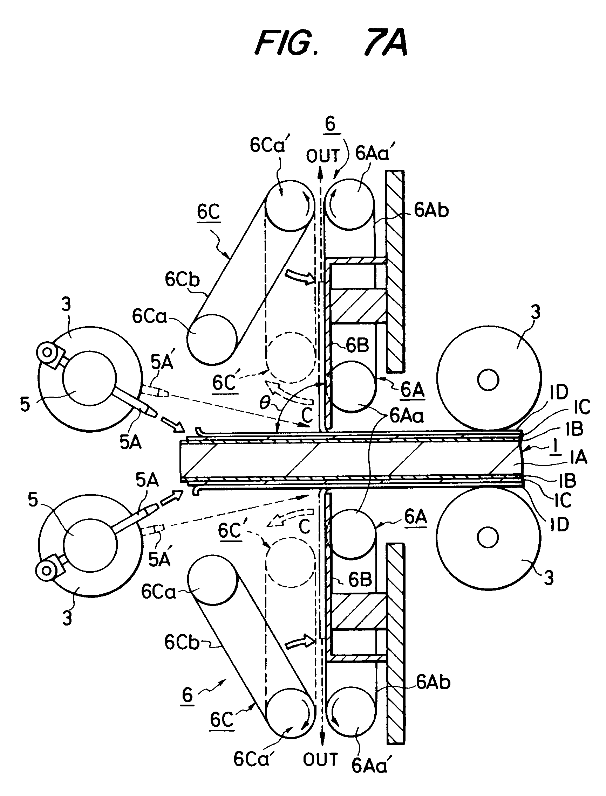

As shown in Figs. 1, 7 and 8, the fluid spray mechanism 5 is so arranged as to sent pressurized fluid such as air, inert gas and liquid such as water from a nozzle 5A and a jet of fluid directly to the gap between the translucent resin film 1D of the printed circuit board 1 and the photosensitive resin layer 1C (of the board). At that time the positioninq of the fluid spray mechanism 5 and the printed circuit board 1 is made by the position detector (not shown) and the conveyance control roller 3. The nozzle 5A may be so arranged as shown by 5A′ of Fig. 7 to make its set angle variable.

The translucent resin film 1D is thus peeled off simply, surely and accurately by sending a jet of fluid to the gap produced by the press member 4A between the tranlucent resin film 1D and the photosensitive layer 1C using the fluid spray mechanism 5.

Each film discharge mechanism 6 consists of a fixed belt conveyor 6A, a film peeling guide member 6B, a moving belt conveyor 6C and a belt mechanism 6D for carrying the film out.

Each belt conveyor 6A, as shown in Figs. 1, 7 and 8, consists of a plurality of pairs of rollers 6Aa, 6Aa′, and a belt 6Ab wound on each pair of rollers 6Aa, 6Aa′.

Each film peeling guide 6B is installed in the case of the film peeling apparatus on the fixed belt conveyor side 6A and the belt 6Ab is allowed to slide on part of the guide face.

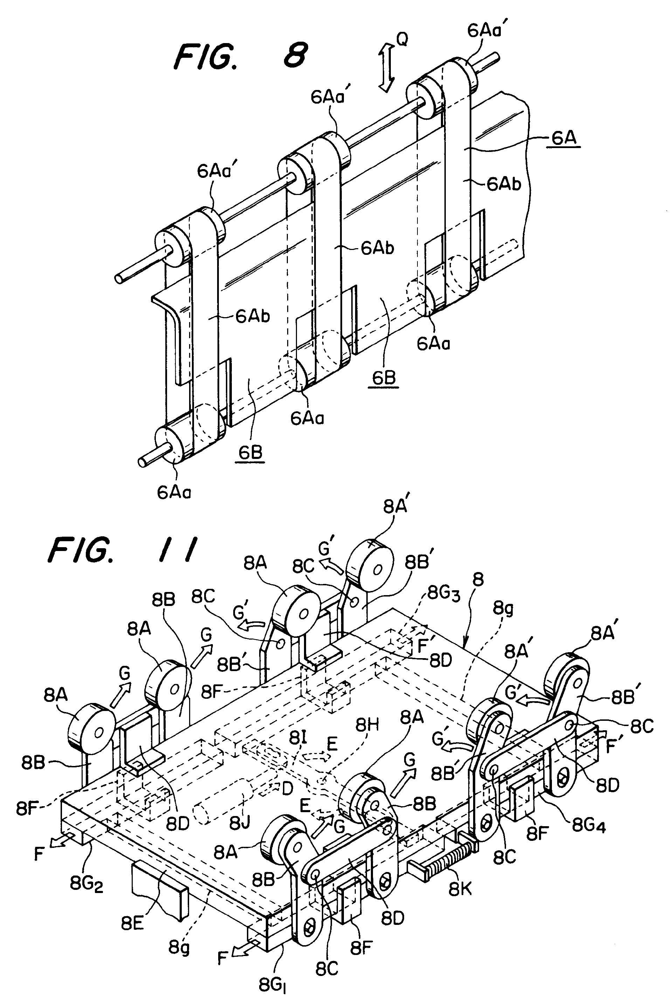

The film peeling guide member 6B is so arranged that the angle of the printed circuit board 1 deprived of the film with the translucent resin film 1D is allowed to vary within the range of an obtuse angle to hold the translucent resin film 1D thus peeled off to a satisfactory extent. In concrete term, the angle at which the film is peeled ranges from 100 to 170 degrees and made variable within that range. The variation of the peel angle by means of the film peeling guide member 6B can be executed by the mechanical means such as gears, crank mechanisms and the like or electrical means such as step-motors. Similarly, the film peeling guide member 6B may be moved linearly as indicated by the arrous Q in Figs. 7 and 8.

The film peeling guide member 6B set at an obtuse angle so as to minimuze the force applied to the photosensitive resin layer 1C freed from the translucent resin film 1D is capable of preventing damage and breakdown to any photosensitive resin layer 1C.

By making the peel angle of the film peeling guide member 6B variable within the range of an obtuse angle, an optimum peel angle can be set in correspondence with the film peel rate and peeling, so that any optimum peel angle can be set, irrespective of the printed circuit board 1 or film peeling condition.

Moreover, the film peeling guide member 6B is so constructed as to make the translucent resin film 1D peeled off by the fluid spray mechanism 5 attach thereto by the indirect fluid pressure derived from the fluid spray mechanism or static electricity generated when the film is peeled off.

Each moving belt conveyor 6C consists, as shown in Figs. 1, 7, a pair of rollers 6Ca, 6Ca′ and a belt 6Cb on the pair of the rollers 6Ca, 6Ca′. The moving belt conveyor 6C is moved by the air cylinder 6Cc with the roller 6Ca′ as the center and so arranged as to move close to or come in contact with the belt 6Ab of the fixed belt conveyor 6A or film peeling guide member 6B. The moving belt conveyor 6C is made to ensure that the translucent resin film 1D thus peeled off by the fluid spray mechanism 5 is held and transferred by the film peeling guide member 6B.

Each film discharge mechanism 6 is composed of the fixed belt conveyor 6A, the film peeling guide member 6B and the moving belt conveyor 6C, so that it becomes possible to make the translucent resin film 1D peeled off by the fluid spray mechanism 5 attach to the film peeling guide member 6B and have the translucent resin film 1D firmly held in between the fixed and moving belt conveyors 6A, 6C and carried out in the direction of an arrow OUT in Fig. 7.

The film discharge mechanism 6D consists, as shown in Fig. 1, of a plurality of rollers 6Da and a pair of belts 6Db and is so arranged as to discharge the translucent resin film located on the upper side of the printed circuit board 1.

The moving belt conveyor 6C may be moved by a solenoid or hydraulic cylinder instead of the air cylinder 6Cc.

Since the press, fluid spray and film discharge mechanisms 4, 5 and 6 are thus installed in the conveyance path of the printed circuit board 1, the gap is formed under the translucent resin film 1D of the printed circuit board 1 and the fluid spray mechanism 5 is then used to peel off the translucent resin film 1D instantly to ensure that the translucent resin film thus peeled off is automatically carried out, so that the time required for the peeling work can be shortened by a large margin.

After the translucent resin film 1D is peeled off with the film discharge mechanism 6, the printed circuit board 1 is carried into a developing device by the conveyance control rollers 3 or and conveyor rollers 2.

Although the press member 4A is employed to press the front face of the translucent resin film 1D of the printed circuit board 1 in its conveyance direction according to the above embodiment, it may also be used to press the end face thereof in the direction perpendicular to the conveyance direction thereof.

Fig. 7A shows the guide mechanism 6 held in a state in which the film peeling member 6B is perpendicular to the board travel path. The film peeling guide member 6B is so designed that, in order to prevent the variation of the peeling position of the translucent resin film 1D, the variation of peeling stress thereof and to prevent the photosensitive resin layer 1C from being damaged or broken, guides the translucent resin film 1D in such a manner that the peeling angle of the latter 1D is obtuse with respect to the direction of conveyance of the printed circuit board 1. That is, the speed of peeling and conveying the translucent resin film 1D is made equal to the speed of conveyance of the printed circuit board 1, or at the start of peeling the speed of conveyance of the printed circuit board is made higher than the speed of peeling and conveying the translucent resin film 1D, so that the peeling angle of the translucent resin film 1D is obtuse with respect to the direction of conveyance of the printed circuit board 1.

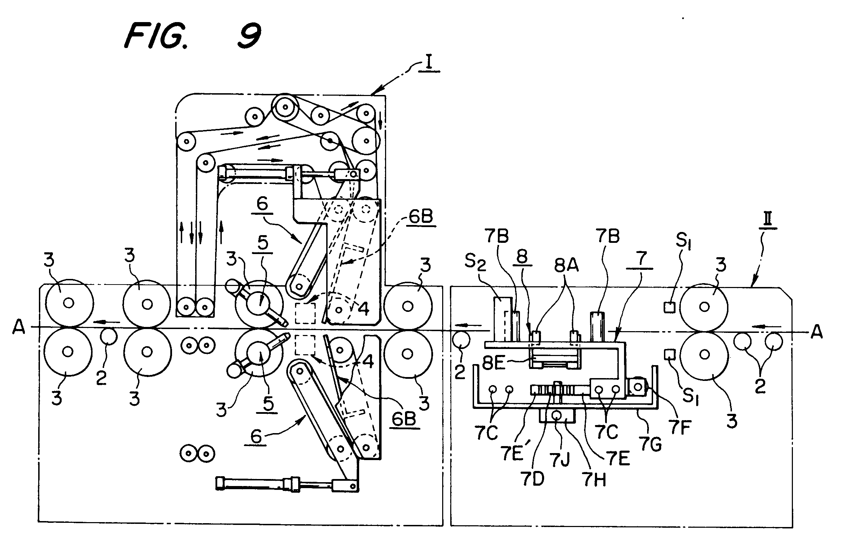

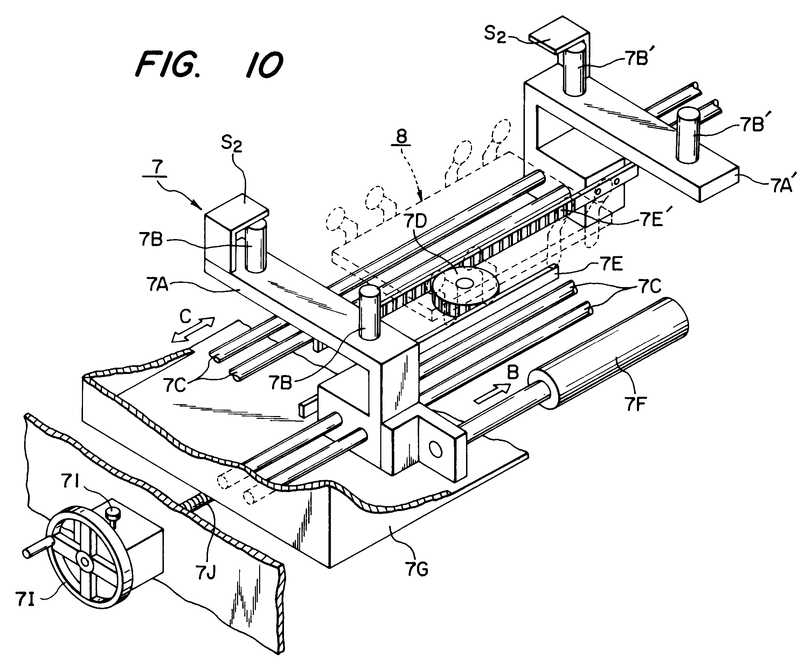

Figs. 9 and 10 show the centering of the board, in accordance with the present invention. Fig. 9 is a schematic view showing a positional relation of the board centering mechanism 7 interposed at a predetermined location of a board conveyor device II. As shown in Fig. 9 and 10, a centerline of the board 1 is aligned with a centerline of the board travelling path in the conveyance direction by the centering mechanism 7. The centering mechanism 7 includes board aligning members 7B, 7B′ carried on support members 7A and 7A′. The board aligning members 7B, 7B′ are located so as to side edges of the board 1 travelling the board conveyance path A-A, so that the centerline of the board 1 is aligned with a centerline of the board conveyor device II. The board aligning members 7B and 7B′ are in the form of cylinders but may be modified to any desired shapes such as planar plates.

The support members 7A and 7A′ are slidably mounted on respective support rods 7C. The support members 7A, 7A′ are caused to cooperate with each other through a pinion 7D and racks 7E and 7E′ which are coupled to the support members 7A and 7A′, respectively. Connected to the support member 7A is an air cylinder 7F having an L-shaped member at its distal end. With such a structure, when a shaft of the air cylinder 7F is moved in a direction indicated by the arrow B, the board aligning members 7B and 7B′ are moved to be close to each other. The board centering mechanism 7 as a whole is supported by a frame 7G.

Engaged with a nut member 7H provided at a bottom of the frame 7G is a screw rod 7J that may be rotated by a controlling handle 7I. The rotation of the control handle 7I causes the frame 7G to move in the widthwise direction indicated by the arrow C. This moving or fine adjusting mechanism is available in the case where the centerlines of the board conveyance path and the centering mechanism 7 are displaced from each other. The fixing action of the moving mechanism may be carried out by a fastening screw 7i for stopping the rotation of the screw rod 7J.

Sensors S₁ shown in Fig. 9 serve to detect a leading or trailing end of the board 1 and apply their signals to drive the board aligning members 7B, 7B′ of the centering mechanism 7. The board position sensors S₁ are supported to a frame of the board conveyor device II. The sensors S₁ may be of the reflex type photosensor, for example.

Board position sensors S₂ shown in Figs. 9 and 10 are adapted to detect the side edges of the board 1, thereby generate driving/stopping signals for the board aligning members 7B, 7B′ of the centering mechanism 7. The sensors S₂ are located at the support members 7A, 7A′ closer to the centerline than the aligning members 7B, 7B′. When the centerlines of the delivery path of the board conveyor device II and the board 1 are aligned with each other, the aligning members 7B, 7B′ are stopped by the signals from the sensors S₂. It is preferable to use delay means for generating signals in a short period after the detection of the side edges of the board 1 by the sensors S₂. The sensors S₂ may be of the transparent photosensor type but is not limited thereto. Also the above-described moving mechanism having the rack and pinion assembly may be modified to various mechanisms. For example, a well known belt and pulley assembly may be used. Instead of the air cylinder 7F, a servo motor may be used so as to directly drive the pinion 7D.

As shown in Figs. 9, 10 and 11, a board lifting mechanism 8 is so constructed as to reduce a friction between the board 1 and the conveyor rollers 2 or conveyor control rollers 3 during the operation of the centering mechanism 7. The lifting mechanism 8 includes movable members 8B, 8B′ and rollers 8A, 8A′ rotatably mounted at first ends the movable members 8B, 8B′. For example, the rollers 8A, 8A′ may be formed of the same material as those of the conveyor controll rollers 3 and the conveyor rollers 2. The movable members 8B, 8B′ are supported rotatably around rotary shafts 8C and are mounted on a frame 8E through T-shaped members 8D. The T-shaped members 8D carry paired movable members 8B, 8B′. The frame 8E is mounted on the frame 7G of the centering mechanism 7. Second ends of the movable members 8B, 8B′ are mounted on slide members 8G₁ to 8G₄ each sliding along guide members 8F formed on the frame 8E. The movable members 8B, 8B′ are rotated around the rotary shafts 8C by the sliding movement of the slide members 8G₁ to 8G₄. The movable members 8B, 8B′ are mounted on the slide members 8G₁ to 8G₄ through relatively large holes so as to rotate smoothly around the rotary shaft 8C. Suitable clearances are formed between the guide memhers 8F and the slide members 8G₁ to 8G₄ so that the slide members 8G₁ to 8G₄ may be smoothly slid.

The slide members 8G₁ and 8G₂ (8G₃ and 8₄) are coupled to each other through a connecting-member 8g to move in the same directions. The slide members 8G₁ and 8G₃ are longer than the slide memhers 8G₂ and 8G₄ and are connected to each other through a rotary memher 8I rotatable about a rotary shaft 8H. The connection between the rotary member 8I and the slide member 8G₁ or 8G₃ is adapted to be pressed by an air cylinder 8J. The connections of the rotary member 8I have oblong holes so as to allow the slide members 8G₁ and 8G₃ to slide. A spring member 8K is interposed between parts of the slide members 8G₁ and 8G₄ to be close to each other.

When the rod of the air cylinder 8 is moved in the direction indicated by the arrow D, the rotary member 8I is rotated in the direction indicated by the arrow E so as to move the slide members 8G₁ to 8G₄ in the directions indicated by the arrows F and F′. The movement of the slide members 8G₁ to 8G₄ causes the rollers 8A, 8A′ to rotate about the rotary shafts 8C in the direction G and G′. The rotation of the rollers 8A, 8A′ causes the board 1 to lift apart from the delivery rollers 2 or control rollers 3.

The board lifting mechanism 8 is operated in accordance with the signals S₁ and S₂ in the same manner as in the centering mechanism 7. Of course, indepensent sensors may be provided for the bord lifting mechanism 8.

Although the above embodiments have been described in reference to the application of the present invention to an appratus for peeling a film off a printed circuit board, it may be applicable to what is used to peel off a protective film covering a decorative laminated sheet.

As set forthe above, the following effects can be accomplished:
1. Since the apparatus for peeling off films stuck onto a board comprises press members for pressing the end faces of films stuck on said board, fluid spray means for sending jets of fluid to the portions of the films thus pressed, and film peeling guide members for setting film peeling directions by changing the peel angles at which the films are peeled off the board using the fluid spray means within the range of an obtuse angle and causing the films thus peeled off to attach thereto, the press members are usable to apply force to the end faces of the films to form gaps thereunder to ensure that the films may be peeled off instantly and accurately by sending jets of fluid thereto, whereas the translucent resin films and photosensitive resin layers are supplied with uniform peeling, which stabilizes the peel positions thereof. Accordingly, the peel position and stress can be prevented from being distorted when the translucent resin film is peeled off and moreover the photosensitive resin layer is prevented from being damaged or broken.
2. Because of 1 , the film stuck onto the board can be peeled off simply, instantly and surely, so that peeling time can be shortened.
3. Since the film discharge means for discharging the film led by the film peeling guide member is installed, film peeling work is automatically carried out, so that peeling time can be shortened further.
4. The means for changing the angle of the film peeling guide member is installed according to 1 , whereby the film can be peeled of at a suitable angle without damaging or breaking it at all times.
5. Since the film discharge means for discharging the film guided with the aid of the film peeling guide member is installed in addition to the construction of 4 , the film peeling work can be automated and the film peeling time is thus shortened.

## Claims

1. An apparatus for peeling off films stuck onto a board, the board being carried in a conveyance path, the apparatus comprising
- press members (4) for pressing the leading surfaces of the films (1D) stuck on the board (1, 1A, 1B),
- fluid spray means (5) for sending jets of fluid to the portions of the films (1D) thus pressed for thereby peeling said portions of the films off the board, and
- a film discharge mechanism (6) comprising film peeling guide members (6B) for attaching the said portions of the films peeled off the board (1, 1A, 1B) by means of the fluid spray means (5), said film peeling guide members (6B) setting an obtuse angle or a right angle, at which the films (1D) are peeled off the board (1),
- said press members (4), said fluid spray means (5) and said film peeling guide members (6B) being installed in the conveyance path of the board,
- said apparatus further comprising means (7) for centering the board (1) in the conveyance path thereof.

2. The apparatus according to claim 1, wherein each of the press members (4) is provided with knurls on the circumference of its rotary body (4A).

3. The apparatus according to claim 1 or 2, wherein each of the press members (4) is arranged so as to move in a predetermined direction after pressing of the outer leading surfaces of the films (1D).

4. The apparatus according to any of claims 1 to 3, wherein the film discharge mechanism (6) for discharging the peeled film (1D) includes fixed belt conveyors (6A) equipped with the film peeling guide members (6B) and moving belt conveyors (6C) for holding the film (1D) stuck on the film peeling guide members (6B).

5. The apparatus according to any of claims 1 to 4, wherein the film peeling directions set by the film peeling guide members (6B) are changed.

6. The apparatus according to any of claims 4 or 5, wherein the film discharge means is arranged so as to discharge the film (1D) by sandwiching the film stuck onto the film peeling guide member (6B) in between the fixed belt conveyor (6A) and the moving belt conveyor (6C).

7. The apparatus according to any of claims 1 to 6, further comprising means (8) for lifting the board in cooperation with the centering means (7).

8. The apparatus according to any of claims 1 to 7, wherein the film peeling guide members (6B) are movable linearly.

## Patentansprüche

1. Vorrichtung zum Abschälen von an einer Platte haftenden Filmen, bei der die Platte von einem Förderweg gefördert wird, mit
- Druckteilen (4) zum Drücken der vorderen Oberfläche des auf der Platte (1, 1A, 1B) haftenden Films (1D),
- einer Flüssigkeitsspritzeinrichtung (5) zum Abgeben von Flüssigkeitsstrahlen an diejenigen Bereiche des Films (1D), auf die auf diese Weise Druck ausgeübt wird, um dadurch diese Bereiche des Films von der Platte abzuschälen, und
- einem Filmabführmechanismus (6) mit Filmabführführungsteilen (6B) zum Anbringen der Bereiche des Films, die von der Platte (1, 1A, 1B) mit Hilfe der Flüssigkeitsspritzeinrichtung (5) abgeschält wurden, wobei die Abschälführungsteile (6B) in einem stumpfen oder rechten Winkel eingestellt sind, bei dem die Filme (1D) von der Platte abgeschält werden,
- wobei die Druckteile (4), die Flüssigkeitsspritzeinrichtung (5) und die Abschälführungsteile (6B) in dem Förderweg der Platte angeordnet sind,
- wobei die Vorrichtung eine Einrichtung (7) zum Zentrieren der Platte (1) auf ihrem Förderweg enthält.

2. Vorrichtung nach Anspruch 1, wobei jede der Druckteile (4) mit Riefelungen versehen ist, die auf dem Umfang ihres Drehkörpers (4A) angeordnet sind.

3. Vorrichtung nach einem der Ansprüche 1 oder 2, wobei jedes der Druckteile (4) so angeordnet ist, daß es sich nach dem Drücken der äußeren vorderen Oberfläche des Films (1D) in eine vorherbestimmte Richtung bewegt.

4. Vorrichtung nach einem der Ansprüche 1 bis 3, in der der Filmabführmechanismus (6) zum Abführen des abgeschälten Films (1D) feststehende Förderbänder (6A) enthält, die mit den Abschälführungsteilen (6B) versehen sind, und sich bewegende Förderbänder (6C) zum Halten des auf den Filmabschälführungsteilen (6B) haftenden Films (1D).

5. Vorrichtung nach einem der Ansprüche 1 bis 4, wobei die Filmabschälrichtungen, die von den Filmabschälführungsteilen (6B) eingestellt sind, geändert werden.

6. Vorrichtung nach einem der Ansprüche 4 oder 5, in der die Filmabführeinrichtung so angeordnet ist, daß sie den Film (1D) abführt, indem der auf dem Filmabschälführungsteil (6B) haftende Film sandwichartig zwischen dem feststehenden Förderband (6A) und dem sich bewegenden Förderweg (6C) gelagert wird.

7. Vorrichtung nach einem der Ansprüche 1 bis 6, des weiteren versehen mit einer Einrichtung (8) zum Anheben der Platte in Zusammenwirkung mit der Zentrierungseinrichtung (7).

8. Vorrichtung nach einem der Ansprüche 1 bis 7, in der die Filmabschälführungsteile (6B) linear bewegbar sind.

## Revendications

1. Appareil de pelage de films adhérant sur une plaquette, la plaquette étant transportée suivant une trajectoire de transport, l'appareil comprenant :
- des organes de pression (4) servant à appliquer une pression sur les surfaces des films (1D) adhérant sur la plaquette (1, 1A, 1B) qui sont disposées en amont dans le sens de déplacement,
- des moyens de pulvérisation de fluide (5) servant à projeter des jets de fluide sur les parties des films (1D) qui sont ainsi soumises à l'application d'une pression, afin de peler de ce fait ces parties des films à l'écart de la plaquette, et
- un mécanisme d'évacuation de film (6) comprenant des organes de guidage de pelage de film (6B) servant à attacher lesdites parties des films qui ont été pelées à l'écart de la plaquette (1, 1A, 1B) à l'aide des moyens de pulvérisation de fluide (5), ces organes de guidage de pelage de film (6B) déterminant un angle obtus ou un angle droit suivant lequel les films (1D) sont pelés à l'écart de la plaquette (1),
- les organes de pression (4), les moyens de pulvérisation de fluide (5) et les organes de guidage de pelage de film (6B) étant montés sur la trajectoire de transport de la plaquette,
- l'appareil comprenant en outre des moyens (7) servant à centrer la plaquette (1) sur la trajectoire de transport de cette plaquette.

2. Appareil selon la revendication 1, dans lequel chacun des organes de pression (4) est pourvu d'un moletage sur la surface cylindrique de son corps rotatif (4A).

3. Appareil selon l'une des revendications 1 et 2, dans lequel chacun des organes de pression (4) est agencé de façon à pouvoir être déplacé suivant une direction prédéterminée après avoir appliqué une pression sur les surfaces amont extérieures des films (1D).

4. Appareil selon l'une quelconque des revendications 1 à 3, dans lequel le mécanisme d'évacuation de film (6) servant à évacuer le film (1D) pelé comprend des bandes transporteuse (6A) fixes qui sont équipées des organes de guidage de pelage de film (6B) et de bandes transporteuses mobiles (6C) servant à maintenir le film (1D) adhérant sur les organes de guidage de pelage de film (6B).

5. Appareil selon l'une quelconque des revendications 1 à 4, dans lequel les directions de pelage de film déterminées par les organes de guidage de pelage de film (6B) font l'objet de modifications.

6. Appareil selon l'une quelconque des revendications 4 et 5, dans lequel les moyens d'évacuation de film sont agencés de façon à évacuer le film (1D) en prenant le film, adhérant sur l'organe de guidage de pelage de film (6B), en sandwich entre la bande transporteuse fixe (6A) et la bande transporteuse mobile (6C).

7. Appareil selon l'une quelconque des revendications 1 à 6, comprenant en outre des moyens (8) servant à soulever la plaquette en coopération avec les moyens de centrage (7).

8. Appareil selon l'une quelconque des revendications 1 à 7, dans lequel les organes de guidage de pelage de film (6B) sont agencés de façon à pouvoir être animés d'un mouvement rectiligne.
